Europäisches Patentamt

European Patent Office

Office européen des brevets

(11) Publication number: **0 252 574**
**A2**

## EUROPEAN PATENT APPLICATION

(21) Application number: 87301300.7

(22) Date of filing: 16.02.87

(51) Int. Cl.⁴: **G03F 1/00**

(30) Priority: 07.07.86 US 882843

(43) Date of publication of application:
**13.01.88 Bulletin 88/02**

(84) Designated Contracting States:
**AT BE CH DE FR GB LI LU NL SE**

(71) Applicant: YEN, Yung-Tsai
**1192 St. Anthony Court**
**Los Altos, CA 94022(US)**

(72) Inventor: **Yen, Yung-Tsai**
**1192 St. Anthony Court**
**Los Altos California 94022(US)**
Inventor: **Wang, Ching-Bore**
**38135 Paseo Padre Court**
**Fremont California 94536(US)**

(74) Representative: **Kerr, Simonne June et al**
**European Patent Attorney POTTS, KERR &**
**CO. 13 High Street**
**Windsor Berkshire SL4 1LD(GB)**

(54) **Method and apparatus for reducing particulates on photomasks.**

(57) A process for fabricating a pellicle is described. The process includes the steps of forming a membrane having an upper side and an underside, and then applying an adhesive substance to the underside of the membrane. This step of applying an adhesive substance normally comprises either spraying or spinning on a non-solidifying liquid. Another aspect of the invention is a pellicle which includes a thin membrane having an upper side and an underside, a frame member having one side mounted to the membrane underside, and an adhesive coating applied to the underside of the membrane.

EP 0 252 574 A2

This invention relates generally to a method and apparatus for reducing particulates on photomasks, and more particularly to a system for preventing particulates from falling from the underside of a pellicle onto the photomask during photolithography.

In recent years, optical membranes known as pellicles have played an important role in the manufacture of semiconductor wafers used in various integrated semiconductor circuits. It has been found that the use of such pellicles has dramatically increased productivity of semiconductor wafer manufacturing operations because of the reduced incidence of quality control rejections based upon the presence of dust or other foreign particulates on the photomask. The presence of such particulate on the photomask will be reproduced on the wafer, so by reducing the amount of particulate on the mask, the quality and therefore the rejection rate of the wafers is dramatically improved.

A typical pellicle takes the form of an extremely thin optical membrane which is mounted to a ring-like frame. This assembly is placed over a photomask during photolithography. Any dust or other particulate which comes in the vicinity of the pellicle-covered photomask will collect on the pellicle membrane. Because the focal point of the lithographic equipment is on the surface of the photomask, any dust which collects on the pellicle membrane will be maintained out of focus and will therefore not appear on the semiconductor wafer.

To minimize the amount of dust and other particulate on a pellicle, pellicles are formed, assembled and packaged in clean rooms. To minimize dust accumulation after packaging but prior to mounting to a photomask, a packaging system such as that disclosed in U.S. Patent No. 4,470,508. This packaging system includes an interior adhesive surface positioned adjacent to an upper surface of the pellicle to collect any dust which has entered the package, thereby minimizing the possibility that such dust will fall on the upper surface of the pellicle.

To prevent the entry of dust onto the underside of the pellicle, a protective covering is applied to the frame in facing relationship but opposite to the pellicle membrane. This protective covering, which is disclosed in a prior patent application filed by Yung-Tsai Yen, entitled "A Method for Producing Contamination-Free Pellicles", Serial No. 06/527,251, has been effective to prevent the entry of additional particulate after the protective covering has been mounted into place.

Despite the prior efforts to minimize the possibility of dust collecting on the pellicle, there is a remote chance of some dust being deposited on the underside of the pellicle membrane after fabrication of the membrane but prior to the mounting of the protective covering to the underside of the frame. In the event such dust does collect on the underside of the pellicle membrane, it is possible that such dust could, once the pellicle is mounted to a photomask, drop onto the photomask surface. As long as the dust adheres on the underside of the pellicle membrane, there will be no problem. This is because the dust will be out of focus during the photolithographic process and will not show up on the semiconductor wafer. However, if the dust drops to the photomask, it could mask or distort the light as it passes through the photomask, thereby presenting the possibility of a defect on the semiconductor wafer.

It is possible to wash the pellicle immediately prior to mounting to the photomask, but this process is time consuming, and difficult to perform effectively. In fact, such washing will often introduce additional particulate onto the pellicle membrane surface.

It is therefore an object of the present invention to overcome the drawbacks and limitations of the prior art proposals. More specifically, the invention has as its objects the following:

(1) to improve the productivity of silicon wafer manufacturing operations by reducing the incidence of dust and other particulate on the photomask;

(2) the provision of a system of fabricating a pellicle which will reduce the likelihood of particulate being deposited on the photomask from the pellicle;

(3) to develop a system for eliminating the necessity of having to pre-wash a pellicle prior to mounting to a photomask;

(4) to provide a system for preventing dust on the underside of a pellicle membrane from falling onto a photomask, which system does not deleteriously affect the transmissivity or other performance specifications of the membrane; and

(5) to develop a system which accomplishes the above objects at a minimum of expense and effort.

The above objects are best achieved by providing a process for fabricating a pellicle which includes the steps of forming a membrane having an upper side and an underside, and then applying an adhesive substance to the underside of the membrane. This step of applying an adhesive substance normally consists of either spraying or spinning on a non-solidifying liquid. The adhesive substances most commonly used with the invention are liquid fluorocarbon or silicon oil.

The invention may also include the step of enclosing an area under the pellicle by extending a protective covering across a side of the frame opposed to the pellicle membrane, so that a first side of the protective covering faces the membrane. Adhesive is usually applied to this first side prior to mounting of the protective membrane so that any dust within the area enclosed by the protective membrane and the pellicle membrane will adhere to the adhesive either on the pellicle membrane or on the protective covering.

The invention may alternatively be described as a pellicle which includes a thin membrane having an upper side and an underside, a frame having one side mounted to the membrane underside, and an adhesive coating applied to the membrane underside.

Therefore, it can be appreciated that any dust which has accumulated within the space under the pellicle membrane will tend to adhere to the membrane and not be deposited on the photomask. In the event that an adhesive-coated protective covering is utilized, this will further reduce the possibility of dust and other particulate being deposited on the photomask. These and other objects, features and advantages of the present invention will become more apparent as this description continues, and when reference is made to the accompanying drawings.

The invention will now be described further, by way of example, with reference to the accompanying drawings, in which

Fig. 1 is a side elevation sectional view of a prior art pellicle mounted to a photomask;

Fig. 2 is a side elevation sectional view of a first embodiment of the present invention, showing the pellicle with a protective covering mounted to it;

Fig. 3 is a side elevation sectional view of the embodiment of Fig. 2, except that the protective covering has been removed and the pellicle is mounted to a photomask; and

Fig. 4 is an enlarged, fragmentary side elevation sectional view of the embodiment of Figs. 2-3, showing the pellicle membrane with an adhesive substance applied to the underside, and - schematically showing two pieces of particulate adhering to the adhesive.

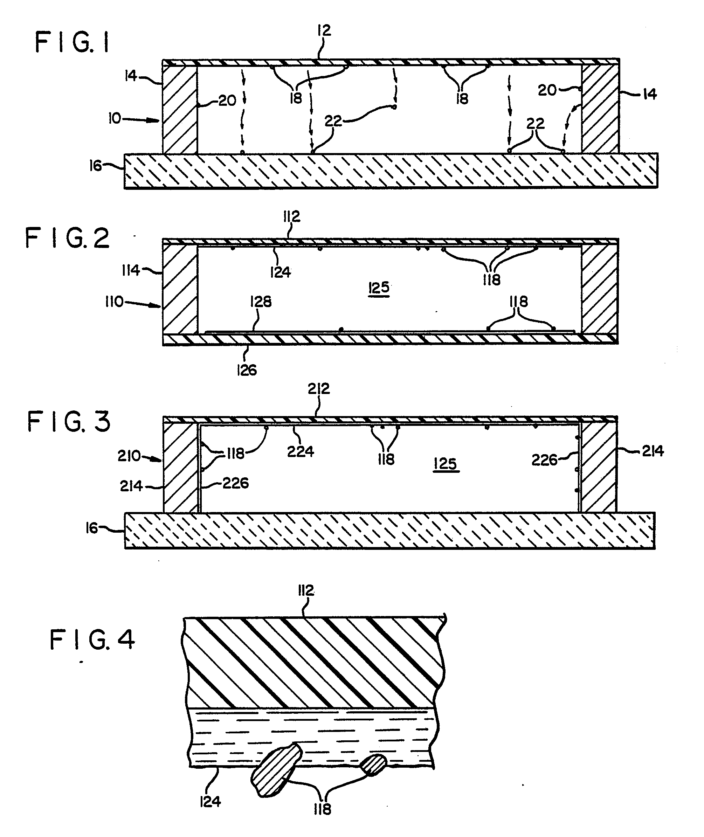

The preferred embodiment of the present invention will be best understood when reference is made to Figs. 2-4. However, before proceeding to a description of these figures and the embodiments depicted therein, reference should first be made to Fig. 1, which depicts a prior art pellicle mounted to a photomask. In Fig. 1, a pellicle has been generally depicted with the numeral 10, with that pellicle being comprised of a thin pellicle membrane 12 bonded to a ring-like, metallic frame member 14. A photomask, to which pellicle 10 is bonded, such as by adhesive (not shown), has been identified at 16. Dust particles have been schematically depicted on the inner or underside of membrane 12 at 18. Dust particles are also schematically shown to be adhering to the inner side of frame member 14, and have been identified with the numeral 20.

Because there is nothing in the prior art configuration to cause these dust particles 18 and 20 to continue to adhere to membrane 12 and frame member 14, the particles will have the possibility of falling onto photomask 16, with such dust particles being identified with the numeral 22. While dust particles 18 and 20 will not adversely affect the photolithography process, once those particles fall onto the surface of photomask 16, they will mask or at least distort the light rays which are passing through the photomask to the semiconductor wafer disposed therebelow. Therefore, they may appear as defects, which would cause quality control rejection of the wafer.

Reference should now be made to Figs. 2-4 which depict two preferred embodiments of the present invention. In Fig. 2, the components of the depicted embodiment which correspond to the conventional pellicle 10 depicted in Fig. 1, will be identified with corresponding numerals except that they will be in the 100 series. Therefore, the pellicle of the present invention has been identified generally with the numeral 110. Pellicle 110 is made up of a pellicle membrane 112 which has an underside that is peripherally mounted by conventional techniques to a ring-like, metal frame member 114. Pellicle membrane 112 is conventional in design, is extremely thin, in the range of about .5 to 5 microns, is very uniform, and exhibits a relatively high transmissivity, in the range of about 80 to 99%. It is typically fabricated of nitrocellulose or another conventionally used pellicle membrane material. It may be fabricated by a spinning process, vapor deposition, or other conventional technique.

Fig. 2 shows that an adhesive substance 124 has been applied to the inner or underside of pellicle membrane 112. This substance, which is in the form of a non-solidifying liquid, is typically sprayed or spun using conventional uniform application techniques. The term "non-solidifying liquid" as used herein means a liquid which can exist for an extended period at atmospheric pressure and room temperature without forming into a solid. Substance 124 should also be one which will not evaporate for an extended period of use at atmospheric pressure and at room temperature. One such material is liquid fluorocarbon. Another such material is conventional silicon oil which is typically used in vacuum pumps. Each of these materials exhibits low boiling points, but will not typically evaporate during use.

Fig. 2 shows a protective covering 126 being applied to the underside of pellicle 110 to enclose the working area 125. This protective covering 126 is typically applied to pellicle 110 shortly before or after mounting of frame member 114 to pellicle membrane 112, and it serves the purpose of preventing the entry of dust and other particulate into the working area 125. Protective covering 126 is typically fabricated of plastic, and normally includes an inner adhesive surface 128, as mentioned above and as described in the afore-referenced patent application. This adhesive surface 128 will also serve to retain any dust which has collected on the surface of protective covering 126, and will collect any dust which may have been present in working area 125.

Fig. 4 shows a fragmentary, enlarged view of the embodiment of Fig. 2, to show the effect of the liquid adhesive surface 124, and how that surface will cause adherence of dust particles 118. Unlike a conventional pellicle membrane surface, such as would be present with pellicle membrane 12, the liquid adhesive surface 124 is sufficiently fluid that particulate 118 thereon will be able to embed itself into the adhesive surface, as schematically shown in Fig. 4. This increases the surface area of adherence, and increases the hold on the dust particles. This is far more effective than the limited surface area contact which would provided by a solid surface such as a conventional membrane 12.

Fig. 3 shows a secondary embodiment of the invention, and in that figure the pellicle is generally identified with the numeral 210, pellicle membrane is identified at 212, frame member is identified at 214, and adhesive substance is identified at 224. Pellicle 210 is shown to be mounted to a conventional photomask 16. The difference between the embodiment of Figs. 2 and 3 is that Fig. 3 shows adhesive substance also to be applied to an inner surface of frame member 214 at 226. Thus, any particulate 118 which has collected on the inner surface of frame member 214 will adhere thereto, and will not fall onto the photomask.

In the embodiment of Fig. 3, the adhesive substance 224 and 226 is typically sprayed onto the underside of pellicle membrane 212 and the inner side of frame member 214 after the frame member has been mounted to the pellicle membrane. This will tend to provide a relatively even distribution of the adhesive substance, which will not adversely affect the transimissivity or other performance characteristics of the pellicle and its membrane 212.

While it is believed that the operation of the present invention will be understood from the above discussion, a brief explanation of the operation of the invention will now follow. For the purposes of this explanation, reference will be made to pellicle 110 depicted in Fig. 2, although it will be apparent that pellicle 210 in Fig. 3 may be utilized in a similar manner.

After pellicle membrane 112 has been formed using conventional techniques, adhesive surface 124 is typically spun onto membrane 112. Protective membrane 126 is then mounted into place, and frame member 114 is adhesively affixed to the peripheral portion of the underside of pellicle membrane 112. The pellicle is then packaged, such as in a package covered by U.S. Patent No. 4,470,508, and is shipped to the user. During shipment, any particulate which is present within working area 125 will typically adhere to adhesive substance 124 on pellicle membrane 112, or to adhesive surface 128 on protective covering 126. Immediately prior to the mounting of pellicle 110 to a photomask 16, protective covering 126 is peeled away. Pellicle 110 is then mounted, such as by adhesive, to photomask 16. Any dust or particulate 118 which has not adhered to adhesive surface 128 on the now-removed protective covering 126, would be adhering to adhesive substance 224 on pellicle membrane 212, and therefore would not fall onto photomask 16. Therefore, the object of reducing the presence of dust and particulate on photomask 16 has been achieved.

While two preferred embodiments of the present invention have been described above, it should be understood that various other modifications and changes in the depicted embodiment may be possible by those with ordinary skill in the art. Such modifications and changes should be considered within the scope of the present invention and are encompassed by the following claims.

## Claims

1. A process for fabricating a pellicle, characterized in that it comprises the steps of forming a membrane (112; 212) having an upper side and an underside; applying a non-solidifying liquid adhesive substance (124; 224) to the underside of the membrane (112; 212) and mounting the membrane to a frame (114; 214) having an inner surface.

2. A process according to claim 1, characterized in that the adhesive substance (226) is applied to the inner surface of the frame (214).

3. A process according to claim 1, characterized in that the adhesive substance is sprayed on to the membrane.

4. A process according to claim 1, characterized in that the adhesive substance is spun on to the membrane.

5. A process according to claim 1, characterized in that the step of applying the adhesive substance comprises applying liquid fluorocarbon.

6. A process according to claim 1, characterized in that the step of applying the adhesive substance comprises applying silicon oil.

7. A process according to claim 1, characterized in that a protective covering (126) is extended across a side of the frame (114) opposed to the membrane so that first side of the protective covering faces the membrane.

8. A process according to claim 7, characterized in that prior to the extending step, adhesive is applied to the first side of the protective covering.

9. A process according to claim 8, characterized in that the pellicle is agitated after the protective covering has been extended and the membrane has been mounted to the frame.

10. A pellicle comprising a thin membrane (112; 212) having an upper side and an underside, a frame member (114; 214) having one side mounted to the membrane underside, characterized in that an adhesive coating (124; 224) is applied to the underside of the membrane.

11. A pellicle according to claim 10, characterized in that the adhesive coating comprises a non-solidifying liquid.

12. A pellicle according to claim 11, characterized in that the liquid comprises fluorocarbon.

13. A pellicle according to claim 11, characterized in that the liquid comprises silicon oil.

14. A pellicle according to claim 10, characterized in that a protective covering (126) is mounted to a second side of the frame for facing the membrane and enclosing an area under the membrane once the membrane has been mounted to the frame member.

15. A pellicle according to claim 14, characterized in that protective covering includes an adhesive coating (128) on the side facing the membrane.

FIG. 1

FIG. 2

FIG. 3

FIG. 4